Europäisches Patentamt

European Patent Office

Office européen des brevets

(11) Numéro de publication : **0 354 124 B1**

(12) **FASCICULE DE BREVET EUROPEEN**

(45) Date de publication du fascicule du brevet :
**05.05.93 Bulletin 93/18**

(51) Int. Cl.⁵ : **G01R 31/04, H01R 43/20**

(21) Numéro de dépôt : **89402200.3**

(22) Date de dépôt : **02.08.89**

(54) **Dispositif de contrôle du bon encliquetage des broches d'une prise multibroches.**

(30) Priorité : **03.08.88 FR 8810492**

(43) Date de publication de la demande :
**07.02.90 Bulletin 90/06**

(45) Mention de la délivrance du brevet :
**05.05.93 Bulletin 93/18**

(84) Etats contractants désignés :
**AT BE CH DE ES GB GR IT LI NL SE**

(56) Documents cités :
**FR-A- 2 585 519**
**GB-A- 2 169 153**
**GB-A- 2 170 962**
**PATENT ABSTRACTS OF JAPAN, vol. 8, no.
177 (M-317)[1614], 15 août 1984, page 40
(M317); & JP-A-59 69 249 (MIYANO TEKKOSHO
K.K.) 19-04-84**
**TECHNICAL DIGEST, no. 57, janvier 1980,
page 7, New York, US; R.G. EBREY et al.:
"Conductor termination and testing apparatus"**

(73) Titulaire : **AEROSPATIALE Société Nationale
Industrielle
37, Boulevard de Montmorency
F-75781 Paris Cédex 16 (FR)**

(72) Inventeur : **Baudron, Jean-Pierre
3 Allée des Rivalettes
F-18230 Saint Doulchard (FR)**
Inventeur : **Beaufils, Laurent
27 rue des Ormes
F-18100 Vierzon (FR)**
Inventeur : **Bonin, Claude
22, rue des Ecoles
F-18200 Saint Amand (FR)**
Inventeur : **Bornet, Christian
26, Avenue Alfred de Vigny
F-18230 - Saint Doulchard (FR)**
Inventeur : **Cortat, Daniel
F-18340 Plaimpied Givaudins (FR)**

(74) Mandataire : **Mongrédien, André et al
c/o SOCIETE DE PROTECTION DES
INVENTIONS 25, rue de Ponthieu
F-75008 Paris (FR)**

Jouve, 18, rue Saint-Denis, 75001 PARIS

## Description

**Dispositif de contrôle du bon encliquetage des broches d'une prise multibroches.**

L'invention concerne un dispositif conçu pour contrôler le bon encliquetage des broches d'une prise multibroches mâle ou femelle.

Dans une prise multibroches, il est nécessaire que toutes les broches de la prise soient bien encliquetées, c'est-à-dire qu'elles puissent résister à l'application d'un effort axial dont l'amplitude varie avec l'utilisation envisagée. En d'autres termes, chacune des broches de la prise doit être maintenue dans cette dernière avec un effort minimal de bon encliquetage ou de rétention déterminé.

Actuellement, le contrôle du bon encliquetage des broches des prises multibroches est généralement effectué manuellement broche par broche, au moyen de dispositifs de contrôle du type peson, tels que celui qui est décrit dans le document FR-A-2 567 272.

Ce type de contrôle est particulièrement long, astreignant et peu fiable. En effet, pour vérifier une prise de 85 broches, l'opérateur devra effectuer 85 contrôles successifs, en risquant de vérifier plusieurs fois la même broche et surtout d'oublier une ou plusieurs d'entre elles. De plus, ce dispositif de contrôle est fragile et risque de se détériorer facilement s'il n'est pas utilisé avec dextérité.

Par ailleurs, on connaît du document FR-A-2 585 136 un dispositif permettant de contôler simultanément le bon encliquetage de toutes les broches d'une prise multibroches. Dans ce dispositif, un vérin permet d'amener simultanément des broches de contrôle mobiles en appui contre les extrémités des broches de la prise. Lorsque l'encliquetage des broches de la prise est correct, cela se traduit par un recul des broches de contrôle à l'encontre d'un ressort, qui est détecté par un contact électrique. Au contraire, lorsqu'une broche de la prise est mal encliquetée, la broche de contrôle correspondante ne recule pas, de sorte qu'aucun contact électrique n'est établi.

Un tel dispositif permet de contrôler rapidement une prise multibroches d'un type bien défini. Cependant, un dispositif différent doit être utilisé pour chaque type de prise. De plus, ce dispositif n'est pas adapté au contrôle de prises présentant un nombre important de broches car il deviendrait alors très complexe puisque le nombre de broches de contrôle du dispositif doit être égal au nombre de broches de la prise.

L'invention a précisément pour objet un dispositif permettant de contrôler le bon encliquetage des broches d'une prise multibroches, conçu de façon à utiliser un nombre de broches de contrôle limité, en ayant recours à des organes de conception simple et facile à mettre en oeuvre.

Conformément à l'invention, ce résultat est obtenu au moyen d'un dispositif de contrôle du bon encliquetage des broches d'une prise multibroches, comprenant un corps équipé de moyens de réception d'une prise à contrôler, un organe mobile en translation vers les moyens de réception à l'intérieur du corps, et des moyens de commande d'un déplacement en translation dudit organe, l'organe mobile portant des broches de contrôle aptes à être amenées en appui sur des broches d'une prise à contrôler placée dans les moyens de réception, lors d'un actionnement des moyens de commande, et des moyens élastiques maintenant normalement chaque broche contre une butée avant de l'organe mobile, avec une force égale à un effort minimal de bon encliquetage des broches de la prise, caractérisé par les fait qu'une partie de l'organe mobile portant les broches de contrôle est montée rotative à l'intérieur du corps autour d'un axe des moyens de réception de la prise, de telle sorte que les broches de contrôle peuvent contrôler successivement plusieurs broches d'une même prise.

Grâce à ces caractéristiques, il est possible, au moyen d'un nombre de broches de contrôle limité, de contrôler en un temps relativement court et sans risque d'oubli l'encliquetage de la totalité des broches d'une prise pouvant comporter un nombre élevé de broches. Ainsi, avec un dispositif de contrôle équipé seulement de 14 broches de contrôle, il est possible de contrôler une prise de 85 broches en effectuant seulement six contrôles successifs séparés par une rotation de 60° de la partie rotative de l'organe mobile.

Afin d'être certain du parfait positionnement angulaire de la partie rotative de l'organe mobile par rapport au corps du dispositif de contrôle, les positions angulaires de cette partie rotative pour laquelle un contrôle peut être effectué sont de préférence déterminées par des moyens d'indexage.

En plus des avantages énoncés précédemment, le dispositif selon l'invention est de préférence conçu de façon à pouvoir être utilisé pour contrôler des prises de dimensions différentes. A cet effet, les moyens de réception de la prise ainsi que les broches de contrôle sont de préférence interchangeables. Dans ce cas, des broches de contrôle mâles ou femelles peuvent être mises en place, selon que la prise à contrôler est une prise femelle ou une prise mâle, respectivement.

Parallèlement, pour permettre le contrôle de prises destinées à des usages variés exigeant un effort d'encliquetage différent des broches, des moyens sont avantageusement prévus pour régler la force exercée par les moyens élastiques sur les broches de contrôle.

Dans un mode de réalisation particulièrement simple du dispositif selon l'invention, les moyens de

EP 0 354 124 B1

commande comprennent un levier articulé sur le corps et dont l'extrémité commande le déplacement en translation d'un arbre coulissant de l'ensemble mobile, supportant ladite partie rotative.

Un exemple de réalisation de l'invention va à présent être décrit, de façon non limitative, en se référant aux dessins annexés dans lesquels :

- la figure 1 est une vue en coupe longitudinale représentant un dispositif de contrôle de l'encliquetage des broches d'une prise multibroches réalisé conformément à l'invention ;
- la figure 2 est une vue en coupe selon la ligne II-II de la figure 1 ;
- les figures 3a à 3d sont des vues en bout représentant quatre types de prises multibroches dont le contrôle de l'encliquetage des broches peut être réalisé à l'aide du dispositif de la figure 1 ;
- la figure 4 est une vue en bout de la grille supportant les broches de contrôle du dispositif de la figure 1, dans le cas où ce dispositif est utilisé pour contrôler une prise 85 broches telle que représentée sur la figure 3d ; et
- la figure 5 illustre de façon schématique la disposition des broches de contrôle de la figure 4 par rapport aux broches de la prise 85 broches de la figure 3d, permettant le contrôle de l'encliquetage de toutes les broches de cette dernière, à l'exception de la broche centrale, par six opérations successives séparées de rotations de 60° des broches de contrôle.

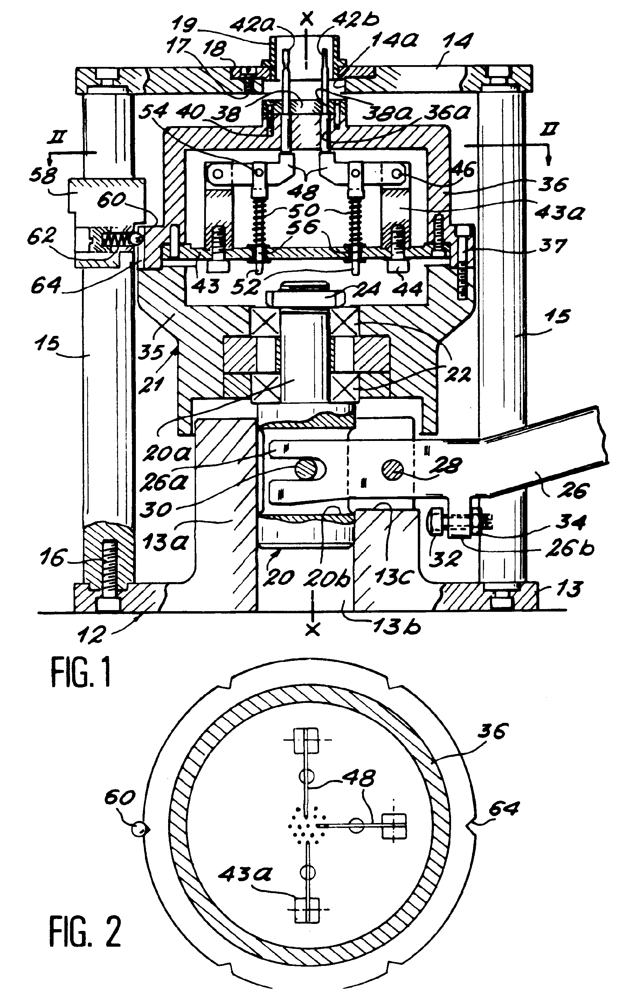

Comme l'illustre la figure 1, le dispositif de contrôle selon l'invention comprend un corps, désigné de façon générale par la référence 12, qui se compose d'une plaque support inférieure 13, d'une plaque supérieure 14, et d'un certain nombre de colonnes 15 (par exemple quatre) par lesquelles la plaque support 13 et la plaque 14 sont reliées de façon rigide et démontable, par exemple au moyen de vis 16.

Les plaques 13 et 14 présentent toutes deux la forme d'un disque de même diamètre, dont l'axe commun X-X est orienté verticalement, dans les conditions normales d'utilisation illustrées sur la figure 1. Les plaques 13 et 14 sont alors horizontales et les colonnes 15, qui relient ces plaques à proximité de leurs bords périphériques, sont verticales.

Le disque constituant la plaque supérieure 14 comporte dans sa partie centrale une ouverture circulaire 14a sur laquelle est fixée de façon démontable, par exemple au moyen de vis 17, une plaque 18 portant un support de prise 19, de forme tubulaire, dont l'axe est confondu avec l'axe commun X-X des plaques 13 et 14.

Le support 19 est conçu pour recevoir une prise multibroches normalisée, de forme cylindrique dans l'exemple représenté, dont on désire contrôler l'encliquetage des broches. Des moyens (non représentés) sont prévus sur ce support 19 afin d'assurer l'immobilisation de la broche à contrôler sur ce support, ainsi que son positionnement angulaire autour de l'axe du support.

Le caractère démontable de la plaque 18 portant le support 19 rend ce dernier interchangeable, ce qui permet de le remplacer lorsqu'on désire contrôler une prise dont les dimensions et/ou la forme sont différentes.

La plaque support inférieure 13 comporte dans sa région centrale une partie tubulaire 13a, en saillie vers la plaque 14 et traversée selon l'axe X-X par un alésage 13b. Dans cet alésage est reçu un arbre cylindrique coulissant 20 dont la partie supérieure 20a, de diamètre réduit, supporte de façon tournante autour de l'axe X-X une partie rotative 21. A cet effet, des paliers 22 maintenus en place par un écrou 24 vissé sur l'extrémité supérieure filetée de la partie 20a de l'arbre coulissant 20 sont interposés entre la partie rotative 21 et la partie 20a de l'arbre 20.

L'ensemble constitué par l'arbre coulissant et la partie rotative 21 constitue ainsi un organe mobile selon l'axe X-X, à l'intérieur du corps 12 du dispositif.

Pour commander le déplacement de cet organe mobile selon l'axe X-X, le dispositif de contrôle est équipé d'un levier ou bras de commande 26 articulé sur la partie tubulaire 13a de la plaque inférieure 13 du corps 12.

Plus précisément, le levier 26 traverse une lumière 13c formée dans la partie tubulaire 13a de la plaque inférieure 13 et il est articulé sur cette partie tubulaire par un axe 28 orthogonal à l'axe de l'alésage 13b. Cet axe 28 est monté dans la partie tubulaire 13a de façon à traverser la partie du levier 26 logée dans la lumière 13c. Le levier 26, qui est orienté approximativement perpendiculairement à l'axe de l'alésage 13b, peut ainsi pivoter autour de l'axe 28 vers le haut et vers le bas, lorsqu'un opérateur manoeuvre une poignée (non représentée) située à l'extrémité du levier 26 faisant saillie à l'extérieur du corps 12.

A son extrémité opposée située à l'intérieur de la partie tubulaire 13a, le levier 26 comporte une fourche 26a qui pénètre dans une encoche 20b traversant radialement et de part en part l'arbre coulissant 20, approximativement au niveau de la lumière 13c. Comme le montre bien la figure 1, l'extrémité fourchue 26a du levier 26 qui pénètre dans l'encoche 20b chevauche un axe 30 traversant radialement l'arbre coulissant 20 au travers de l'encoche 20b de façon à être orienté parallèlement à l'axe 28. Cette disposition permet d'immobiliser en rotation l'arbre coulissant 20 à l'intérieur de la plaque inférieure 13 du corps. Elle permet aussi de transformer tout mouvement de pivotement du levier 26 autour de son axe 28 en un mouvement de translation de l'arbre 20 et, par conséquent, de l'organe mobile constitué par cet arbre et par la partie rotative 21, à l'intérieur du corps 12 selon l'axe X-X.

Afin de limiter le déplacement vers le haut de cet organe mobile en considérant la figure 1, lors d'un actionnement du levier 26, ce dernier comporte de préférence, dans sa partie située à l'extérieur de la partie tubulaire 13a de la plaque 13, une excroissance 26b supportant une butée 32 apte à venir en appui sur la surface extérieure de la partie tubulaire 13a, pour limiter la course de déplacement vers le haut de l'organe mobile. De préférence, la butée 32 est réglable. Dans ce cas, elle peut notamment être constituée par une tige filetée vissée dans l'excroissance 26b du levier et qui peut être immobilisée au moyen d'un écrou 34.

La partie rotative 21 de l'organe mobile présente de façon générale une symétrie de révolution autour de l'axe X-X, qui constitue son axe de rotation.

Comme l'illustre la figure 1, cette partie rotative 21 se compose d'une pièce inférieure 35, en forme de cloche retournée, montée sur la partie 20a de l'arbre 20 par les paliers 22, et d'une pièce supérieure 36. La pièce supérieure 36 comporte une paroi périphérique cylindrique fixée sur la pièce inférieure 35 par exemple au moyen de vis 37 et une paroi supérieure plane située à proximité de la plaque supérieure 14 du corps et orientée parallèlement à celle-ci.

Dans sa partie centrale située en face du support de prise amovible 19, la paroi supérieure plane de la pièce 36 est traversée parallèlement à l'axe X-X par un certain nombre de perforations 36a. Comme on le verra ultérieurement, le nombre de ces perforations ainsi que leurs emplacements sont choisis selon l'agencement des broches des différentes prises que l'on désire pouvoir contrôler. Plus précisément, ces caractéristiques sont déterminées afin de permettre, après plusieurs rotations de la partie rotative 21, le contrôle des prises dont le nombre de broches est le plus important, parmi toutes les prises à contrôler.

Une grille amovible 38 est fixée de façon démontable, par exemple au moyen de vis 40, au-dessus de la partie centrale de la paroi supérieure plane de la pièce 36 présentant les perforations 36a. Cette grille 38 comporte des perforations 38a dont le nombre et la disposition sont identiques à ceux des perforations 36a lorsqu'elle est fixée sur la pièce supérieure 36. Cependant, le diamètre des perforations 38a de la grille est légèrement inférieur à celui des perforations 36a.

Cet agencement particulier permet à la grille 38 de servir de butée à des broches de contrôle interchangeables 42a ou 42b qui sont placées dans les perforations alignées de la pièce 36 et de la grille 38. A cet effet, chacune des broches de contrôle comporte une partie inférieure de grand diamètre apte à être placée dans l'une des perforations 36a et une partie supérieure de plus petit diamètre traversant les perforations 38a de la grille 38 et dont l'extrémité a la forme d'une broche femelle 42a ou d'une broche mâle 42b, selon que la prise à contrôler est une broche mâle ou une broche femelle, respectivement. De façon plus précise, avant le contrôle d'une prise, l'opérateur démonte la grille 38 pour mettre en place dans les perforations 36a désirées les broches de contrôle 42a ou 42b nécessaires au contrôle de la prise dont on désire vérifier le bon encliquetage des broches.

A proximité de la jonction des pièces 35 et 36 de la partie rotative 21, une plaque support horizontale 43 est fixée à la pièce 36, par exemple au moyen de vis 44. Cette plaque 43 comporte sur sa face supérieure des parties en saillie 43a sur lesquelles sont articulés, par des axes 46 orientés orthogonalement à l'axe X-X des leviers de contrôle 48 dirigés radialement vers cet axe. Le nombre des leviers 48 est égal au nombre des perforations 36a, de sorte que l'extrémité de chacun des leviers opposée à son extrémité articulée sur l'axe 46 se trouve normalement en face de l'extrémité inférieure de l'une des broches de contrôle 42a ou 42b, comme l'illustre la figure 2.

A chacun des leviers 48 est associé un ressort hélicoïdal de compression 50 qui est monté sur une tige 52 articulée par son extrémité supérieure sur le levier 48 correspondant, autour d'un axe 54 parallèle à l'axe d'articulation 46 de ce levier. Chaque tige 52 traverse librement une douille 56 vissée dans la plaque 43, de telle sorte que la tige soit approximativement parallèle à l'axe X-X. Le ressort 50 monté sur chaque tige 52 prend appui par son extrémité supérieure sur un épaulement formé sur cette tige 52 et, par son extrémité inférieure, sur la douille 56.

De cette manière, l'extrémité de chacun des leviers 48 est maintenue en appui contre l'extrémité inférieure de l'une des broches de contrôle, ce qui a pour effet d'appliquer normalement ces dernières contre la grille 38 avec une force prédéterminée par la précontrainte emmagasinée par les ressorts 50. Cette précontrainte peut être réglée en vissant ou en dévissant plus ou moins les douilles 56 dans la plaque 43.

Pour compléter le dispositif de contrôle qui vient d'être décrit, celui-ci comporte également des moyens d'indexage permettant de déterminer les positions angulaires de la partie rotative 21 autour de l'axe X-X dans lesquelles un contrôle peut être effectué.

Dans l'exemple de réalisation représenté, ces moyens d'indexage comportent un support 58 fixé sur l'une des colonnes 15 du corps 12. Ce support porte un doigt d'indexage constitué par exemple par une bille 60 sollicitée élastiquement par un ressort 62 contre la surface périphérique extérieure de la pièce 36. Etant donné que cette dernière comporte des rainures axiales 64 (figure 2) réparties à intervalles réguliers sur toute sa circonférence, la partie rotative 21 est immobilisée en rotation lorsque la bille 60 est logée dans l'une de ces rainures 64. De préférence, la force appliquée sur la bille 60 par le ressort 62 est réglable.

Dans le cas illustré sur la figure 2 où le contrôle d'une prise nécessite six contrôles successifs séparés par des rotations de 60° de la partie 21, les rainures 64 sont elles-mêmes réparties à 60° les unes des autres autour de l'axe de cette partie 21. De cette manière, l'opérateur peut aisément amener la partie 21 dans une position de contrôle en la faisant tourner manuellement pour amener successivement chacune des rainures 64 en face du doigt d'indexage 60, qui assure alors automatiquement le positionnement et l'immobilisation en rotation de la partie 21.

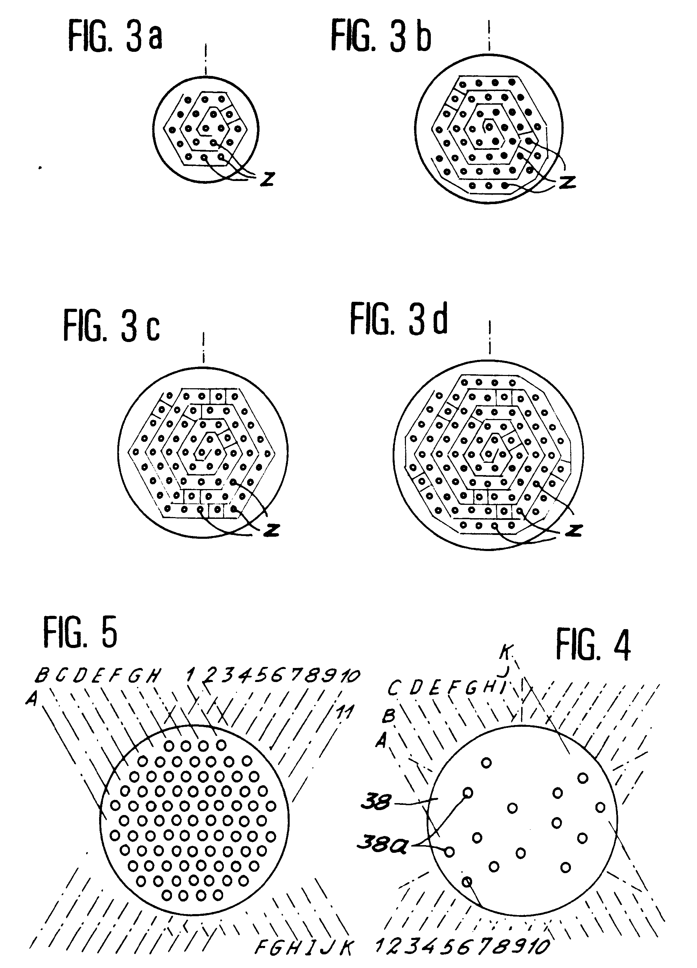

Les figures 3a, 3b, 3c et 3d représentent respectivement des prises circulaires usuelles de 19 broches, 44 broches, 61 broches et 85 broches, qui peuvent toutes être contrôlées à l'aide du dispositif de la figure 1. Sur chacune de ces figures, les broches, sont désignées par la référence Z. Ces prises se caractérisent toutes par le fait que les broches Z sont réparties selon un réseau hexagonal régulier, à l'intersection de deux séries de droites parallèles et régulièrement espacées désignées par les références A à K et 1 à 11 sur les figures 4 et 5, les droites des deux séries formant entre elles un angle de 60°. De plus, selon le nombre de broches, celles-ci se trouvent encerclées par un cercle centré sur l'axe de la prise et dont le rayon va en augmentant de la prise à 19 broches de la figure 3a vers la prise à 85 broches de la figure 3d.

Afin que le dispositif selon l'invention puisse contrôler toutes les sortes de prises illustrées sur les figures 3a à 3d, il comporte en principe un nombre de perforations 36a suffisant pour contrôler une prise de 85 broches tel qu'illustré sur la figure 3d, c'est-à-dire, comme on le verra ultérieurement, 14 perforations 36a, aptes à recevoir 14 broches de contrôle 42a ou 42b, ainsi que 14 ensembles leviers 48-ressorts 50 associés à ces perforations.

Cependant, pour simplifier l'exposé, on expliquera tout d'abord la mise en oeuvre du dispositif selon l'invention en se référant à la figure 2 qui représente seulement trois ensembles leviers 48-ressorts 50 permettant le contrôle d'une prise multibroches de 19 broches telle que représentée que la figure 3a.

Dans ce cas, on met en place trois broches de contrôle femelles 42a, si la prise à contrôler est une prise mâle, ou trois broches de contrôle mâles 42b, si la prise à contrôler est une prise femelle. Ces trois broches de contrôle sont placées dans les perforations F5, H8 et E7 (figures 4 et 5) de la pièce 36, la grille 38 étant retirée. La grille 38 est ensuite mise en place à l'aide des vis 40, ainsi que l'ensemble plaque 18-support de prise 19 adapté à la prise 19 broches de la figure 3a.

La prise à contrôler étant placée dans le support 19 et la partie rotative 21 étant immobilisée dans une première position angulaire par la bille 60, l'opérateur actionne le levier 26. Les trois broches de contrôle sont ainsi amenées en appui contre trois des broches Z de la prise à contrôler.

Si l'effort d'encliquetage de ces broches Z est au moins égal à un effort minimal de bon encliquetage déterminé par les ressorts 50 et réglé au préalable à l'aide des douilles 56, les broches de contrôle reculent en comprimant les ressorts 50.

Au contraire, si l'effort d'encliquetage ou de rétention d'au moins l'une des broches contrôlées est inférieur à l'effort minimal désiré, la broche de contrôle correspondante repousse cette broche Z.

Bien entendu, bien que le contrôle puisse être fait par une simple observation visuelle du comportement des leviers 48 ou des tiges 52, le dispositif comporte de préférence des moyens, électriques ou autres, permettant d'afficher automatiquement le ou les broches défectueuses.

Si l'encliquetage des broches contrôlées est satisfaisant, l'opérateur relâche le levier 26 et fait tourner manuellement de 60° la partie rotative 21, en s'aidant des moyens d'indexage 60, 64.

Lorsque l'opérateur détecte une broche mal encliquetée, il la remet en place après avoir relâché le levier 26, puis effectue un nouveau contrôle.

En effectuant six contrôles successifs à l'aide des trois broches de contrôle décrites, un opérateur peut ainsi contrôler en un temps très court et de façon totalement fiable une prise de 19 broches. La broche Z centrale de la prise peut être contrôlée soit séparément au moyen d'un dispositif classique du type peson soit, de préférence, en adjoignant au dispositif de l'invention une broche de contrôle centrale et un ressort précontraint associé.

Comme on l'a mentionné précédemment, le dispositif selon l'invention est conçu, de préférence, pour pouvoir contrôler à volonté l'une quelconque des prises des figures 3a à 3d, par un simple changement du nombre des broches de contrôle 42a ou 42b et de l'ensemble plaque 18-support de prise 19.

Sur la figure 4, on a représenté la répartition des perforations 38a de la grille 38 adaptée pour contrôler l'une quelconque des broches des figures 3a à 3d par six opérations de contrôle successives séparées par des rotations de 60° de la partie rotative 21 du dispositif. Comme on l'a déjà mentionné, les perforations 36a sont disposées selon le même schéma et les leviers 48 sont agencés de façon à venir obturer, sous l'action de leurs ressorts 50 associés, l'extrémité de chacune des perforations 36a.

Comme le montre la figure 4, les perforations 38a de la grille 38 sont au nombre de 14 et elles sont positionnées en F5-H8-E7-I7-C4-C6-D2-F2-G10-I10-A3-A5-K8-K10 (figures 4 et 5), de façon à permettre le contrôle de toutes les broches de la prise 85 broches de la figure 3d, à l'exception de la broche centrale, à l'aide de 14 broches de contrôle, par les six contrôles successifs apparaîssant sur le tableau I :

## TABLEAU I

| N° du contrôle | Broches contrôlées (figure 5) |
|---|---|
| 1 | F5-H8-E7-I7-C4-C6-D2-F2-G10-I10-A3-A5-K8-K10- |
| 2 | G8-D5-F6-C3-E3-H9-C7-E9-H4-J6-B1-D1-G11-I11- |
| 3 | G7-D6-E4-E3-F3-H5-G3-B5-J8-J10-B7-D9-G2-I4- |
| 4 | F7-D4-G5-C5-I6-I8-C2-E2-F10-H10-A2-A4-K7-K9 |
| 5 | E6-F4-H7-D3-G9-I9-B6-D8-G3-I5-C1-E1-H11-J11- |
| 6 | E5-G6-H6-D7-F9-G4-B2-B4-J7-J9-C6-E10-H3-J5- |

Bien entendu, lorsqu'on désire contrôler une prise plus petite telle que l'une des prises des figures 3a, 3b ou 3c, on ne met en place dans les perforations 36a et 38a que les broches 42a ou 42b nécessaires au contrôle de cette prise.

Ainsi, comme on l'a déjà mentionné, pour vérifier la prise 19 broches de la figure 3a, seules trois broches de contrôle sont positionnées en F5, H8 et E7.

Pour la prise 44 broches de la figure 3b, neuf broches de contrôle sont positionnées en F5-H8-E7-I7-C4-C6-D2-I10-G10.

Enfin, pour une prise 61 broches telle qu'illustrée sur les broches de contrôle positionnées en F5-H8-E7-I7-C4-C6-D2-F2-G10-I10.

Ainsi, en ayant recours à des mécanismes simples et faciles à mettre en oeuvre, le dispositif selon l'invention permet de contrôler de façon sûre et en un temps très court des prises de différents types dont les broches sont agencées selon un même réseau.

De plus en changeant simplement la pièce 36 de la partie rotative 21, on peut adapter le dispositif au contrôle de prises dont les broches sont agencées selon un réseau différent, puisque cette pièce 36, qui comporte les perforations 36a, supporte également les ensembles leviers 48-ressorts 50, par l'intermédiaire de la plaque 43, et comporte les rainures d'indexage 64.

## Revendications

1. Dispositif de contrôle du bon encliquetage des broches d'une prise multibroches, comprenant un corps (12) équipé de moyens de réception (19) d'une prise à contrôler, un organe (20,21) mobile en translation vers les moyens de réception à l'intérieur du corps, et des moyens de commande (26) d'un déplacement en translation dudit organe, l'organe mobile portant des broches de contrôle (42a,42b) aptes à être amenées en appui sur des broches d'une prise à contrôler placée dans les moyens de réception, lors d'un actionnement des moyens de commande, et des moyens élastiques (50) maintenant normalement chaque broche contre une butée (38) avant de l'organe mobile, avec une force égale à un effort minimal de bon encliquetage des broches de la prise, caractérisé par le fait qu'une partie (21) de l'organe mobile portant les broches de contrôle (42a,42b) est montée rotative à l'intérieur du corps (12) autour d'un axe (X-X) des moyens de réception (19) de la prise, de telle sorte que les broches de contrôle peuvent contrôler successivement plusieurs broches d'une même prise.

2. Dispositif selon la revendication 1, caractérisé par le fait qu'il comprend des moyens d'indexage (60,64) de ladite partie rotative (21) par rapport au corps (12), déterminant des positions angulaires de la partie rotative pour lesquelles un contrôle peut être effectué.

3. Dispositif selon la revendication 2, caractérisé par le fait que les moyens d'indexage (60,64) déterminent six positions angulaires de contrôle aptes à être obtenues par des rotations successives de 60° de la partie rotative (21) de l'organe mobile dans le corps (12).

4. Dispositif selon l'une quelconque des revendications 1 à 3, caractérisé par le fait que les moyens de réception (19) de la prise ainsi que les broches de contrôle (42a, 42b) sont interchangeables.

5. Dispositif selon la revendication 4, caractérisé par le fait que les broches de contrôle comprennent des broches mâles (42b) et des broches femelles (42a), respectivement pour le contrôle d'une prise femelle et d'une prise mâle.

6. Dispositif selon l'une quelconque des revendications précédentes, caractérisé par le fait que des moyens (56) sont prévus pour régler la force exercée par les moyens élastiques (50) sur les broches de contrôle (42a, 42b).

7. Dispositif selon l'une quelconque des revendications précédentes, caractérisé par le fait que les moyens de commande comprennent un levier (26) articulé sur le corps (12) et dont l'extrémité commande le déplacement en translation d'un arbre coulissant (20) de l'ensemble mobile, supportant ladite partie rotative (21).

8. Dispositif selon l'une quelconque des revendications précédentes, caractérisé par le fait que la partie rotative (21) de l'organe mobile comporte une pièce interchangeable (36) munie de perforations (36a) dans lesquelles sont logées les broches de contrôle (42a,42b) et supportant les moyens élastiques (50).

**Patentansprüche**

1. Vorrichtung zur Prüfung des richtigen Einrastens der Kontaktstifte eines mehrpoligen Steckverbinders, umfassend ein Gehäuse (12), das versehen ist mit Aufnahmemitteln (19) für einen zu prüfenden Steckverbinder, eine Einrichtung (20, 21), beweglich in Längsrichtung auf die Aufnahmemittel im Innern des Gehäuses zu, und Betätigungsmittel (26) für ein Verschieben in Längsrichtung der genannten Einrichtung, wobei die bewegliche Einrichtung Prüfstifte (42a, 42b) trägt, die sich bei einer Betätigung der Betätigungsmittel gegen die Kontaktstifte eines in den Aufnahmemitteln befindlichen, zu prüfenden Steckverbinders drücken lassen, und elastische Mittel (50), die normalerweise jeden Kontaktstift nahe bei einem beschlag (38) halten, vor der beweglichen Einrichtung, mit einer Kraft entsprechend dem minimalen Aufwand für richtiges Einrasten der Kontaktstifte des Steckverbinders,
dadurch **gekennzeichnet,**
daß ein die Prüfkontaktstifte (42a, 42b) tragendes Teil (21) der beweglichen Einrichtung im Innern des Gehäuses (12) drehbar um eine Achse (X-X) der Aufnahmemittel (19) des Steckverbinders montiert ist, so daß die Prüfkontaktstifte nacheinander mehrere Kontaktstifte desselben Steckverbinders prüfen können.

2. Vorrichtung nach Anspruch 1, dadurch gekennzeichnet, daß sie Indexierungsmittel (60, 64) des genannten drehbaren Teils (21) bezogen auf das Gehäuse (12) enthält, die für das drehbare Teil Winkelpositionen festlegen, in denen Messungen durchgeführt werden können.

3. Vorrichtung nach Anspruch 2, dadurch gekennzeichnet, daß die Indexierungsmittel (60, 64) sechs Prüfungswinkelpositionen festlegen, die erreicht werden können durch aufeinanderfolgende Drehungen um 60° des drehbaren Teils (21) der beweglichen Einrichtung in dem Gehäuse (12).

4. Vorrichtung nach einem der Ansprüche 1 bis 3, dadurch gekennzeichnet, daß die Aufnahmemittel (19) des Steckverbinders ebenso wie die Prüfkontaktstifte (42a, 42b) austauschbar sind.

5. Vorrichtung nach Anspruch 4, dadurch gekennzeichnet, daß die Prüfstifte Steckerstifte (42b) und Steckbuchsenstifte (42a) umfassen, jeweils für die Prüfung einer Steckbuchse und eines Steckers.

6. Vorrichtung nach einem der vorhergehenden Ansprüche, dadurch gekennzeichnet, daß die Mittel (56) dazu vorgesehen sind, die von den elastischen Mitteln (50) auf die Prüfstifte (42a, 42b) ausgeübte Kraft zu regulieren.

7. Vorrichtung nach einem der vorhergehenden Ansprüche, dadurch gekennzeichnet, daß die Betätigungsmittel einen Hebel (26) enthalten, der am Gehäuse (12) gelenkig montiert ist und dessen Ende die Längsbewegung einer verschiebbaren Achse (20) des beweglichen Aufbaus betätigt, auf der das genannte drehbare Teil (21) sitzt.

8. Vorrichtung nach einem der vorhergehenden Ansprüche, dadurch gekennzeichnet, daß das drehbare Teil (21) der beweglichen Einrichtung ein austauschbares Teil (36) aufweist, das mit Durchbohrungen (36a) versehen ist, in denen die Prüfstifte (42a, 42b) gelagert sind und das die elastischen Mittel (50) trägt.

## Claims

1. Device for checking that the pins of a multi-pin plug are correctly clipped in, which device comprises a body (12) equipped with means (19) for receiving a plug to be checked, a member (20, 21) which can move translationally towards the reception means inside the body, and control means (26) for causing a translational displacement of the said member, the movable member carrying checking pins (42a, 42b) able to be brought to bear on the pins of a plug to be checked placed in the reception means, when the control means are actuated, and elastic means (50) normally holding each pin against a front stop (38) of the movable member, with a force equal to a minimum force for correctly clipping in the pins of the plug, characterised in that a part (21) of the movable member carrying the checking pins (42a, 42b) is mounted so as to rotate inside the body (12) about an axis (X-X) of the means (19) for receiving the plug, so that the checking pins can successively check several pins of the same plug.

2. Device according to Claim 1, characterised in that it comprises means (60, 64) for indexing the said rotary part (21) with respect to the body (12), determining angular positions of the rotary part at which positions a check can be carried out.

3. Device according to Claim 2, characterised in that the indexing means (60, 64) determine six angular checking positions able to be obtained by successive rotations through 60° of the rotary part (21) of the movable member in the body (12).

4. Device according to any one of Claims 1 to 3, characterised in that the means (19) for receiving the plug and the checking pins (42a, 42b) are interchangeable.

5. Device according to Claim 4, characterised in that the checking pins comprise male pins (42b) and female pins (42a), for checking a female plug and a male plug respectively.

6. Device according to any one of the preceding claims, characterised in that means (56) are provided for adjusting the force exerted by the elastic means (50) on the checking pins (42a, 42b).

7. Device according to any one of the preceding claims, characterised in that the control means comprise a lever (26) articulated to the body (12) and whose end causes the translational displacement of a sliding shaft (20) of the movable assembly, supporting the said rotary part (21).

8. Device according to any one of the preceding claims, characterised in that the rotary part (21) of the movable member comprises an interchangeable component (36) equipped with perforations (36a) in which the checking pins (42a, 42b) are housed, and supporting the elastic means (50).

FIG. 1

FIG. 2

FIG. 3 a

FIG. 3 b

FIG. 3 c

FIG. 3 d

FIG. 5

FIG. 4